Europäisches Patentamt

European Patent Office

Office européen des brevets

(11) Veröffentlichungsnummer: **0 464 910 A2**

# EUROPÄISCHE PATENTANMELDUNG

(21) Anmeldenummer: **91201585.6**

(22) Anmeldetag: **20.06.91**

(51) Int. Cl.5: **H04L 25/49**, H04L 5/02

(30) Priorität: **30.06.90 DE 4020963**

(43) Veröffentlichungstag der Anmeldung:
**08.01.92 Patentblatt 92/02**

(84) Benannte Vertragsstaaten:
**DE FR GB**

(71) Anmelder: **Philips Patentverwaltung GmbH
Wendenstrasse 35 Postfach 10 51 49
W-2000 Hamburg 1(DE)**

(84) **DE**

Anmelder: **N.V. Philips' Gloeilampenfabrieken
Groenewoudseweg 1**

**NL-5621 BA Eindhoven(NL)**

(84) **FR GB**

(72) Erfinder: **Götz, Hans-Joachim, Dr.-Ing.
Schweinauer Hauptstrasse 29
W-8500 Nürnberg 20(DE)**
Erfinder: **Hembes, Rainer, Dipl.-Ing.
Obergasse 16
W-6501 Ober-Olm(DE)**

(74) Vertreter: **Volmer, Georg et al
Philips Patentverwaltung GmbH
Wendenstrasse 35, Postfach 10 51 49
W-2000 Hamburg 1(DE)**

(54) **Übertragungseinrichtung mit einem blockcode-codiertem Hauptkanal und mit einem Zusatzkanal.**

(57) 2.1. Bekannt sind Übertragungseinrichtungen für digitale Übertragungsstrecken mit einem blockcode-codiertem Hauptkanal und mit einem Zusatzkanal, bei denen der Zusatzkanal aufgrund einer Coderegelverletzung realisiert wird.

2.2. Um einen Zusatzkanal zu schaffen, der mit möglichst geringem schaltungstechnischem Aufwand auskommt, wird vorgeschlagen, daß der Zusatzkanal mit einem zweiten ausgewogenen Blockcode getrennt codiert ist und der zu übertragende Datenstrom wechselweise aus einem oder mehreren Blökken des Hauptkanals und einem Bit des block-codierten Zusatzkanals zusammengesetzt ist, wobei der für den Zusatzkanal verwendete Blockcode gegenüber dem für den Hauptkanal verwendeten Blockcode einen einfacheren Aufbau aufweist.

2.3. Die Erfindung eignet sich vorzugsweise für Glasfaserübertragungseinrichtungen.

FIG.2

Die Erfindung betrifft eine Übertragungseinrichtung für eine digitale Übertragungsstrecke mit einem blockcode-codiertem Hauptkanal und mit einem Zusatzkanal.

In digitalen Übertragungseinrichtungen besteht oft der Bedarf, neben den zu übertragenden Daten zusätzliche Daten über die gleiche Übertragungseinrichtung zu übertragen. Versinnbildlicht spricht man auch davon, daß die hautsächlich zu übertragenden Daten in einem Hauptkanal und die zusätzlich übertragenen Daten in einem Zusatzkanal übertragen werden. Die Datenrate des Zusatzkanals ist wesentlich geringer als die Datenrate des Hauptkanals. Der Zusatzkanal wird meist für Telemetriedaten oder aber für Sprechverbindungen als sogenannter Dienstkanal verwendet.

Im Hauptkanal wird oft zur Fehlersicherung ein Blockcode verwendet, bei dem jeweils n aufeinanderfolgende Datenelemente zu einem aus m (m größer als n) Bits bestehenden Codewort zusammengefaßt werden. Ein solcher Blockcode, bei dem jeweils fünf binäre Datenelemente zu einem sechsstelligen binären Datenwort zusammengefaßt werden, wird bei der Deutschen Bundespost in 140 MBit/s Glasfaserübertragungsstrecken verwendet.

Aus DE 35 22 130 ist beispielsweise eine digitale Übertragungsstrecke mittels Lichtwellenleitern, mit einem Leitungsendgerät am Anfang der Strecke und mit einem Leitungsendgerät am Ende der Strecke sowie mit einem über den Lichtwellenleiter geführten Hauptkanal mit 5-Bit/6-Bit-Codierung bekannt. In dem Hauptkanal ist ein auf der Coderedundanz der 5 Bit/6 Bit-Codierung beruhender Zusatzkanal eingebettet. Dem Leitungsendgerät am Anfang der Strecke ist ein 5 Bit/6 Bit-Codierer mit Zusatzkanalcodierer und dem Leitungsendgerät am Ende der Strecke ein 6-Bit/5-Bit-Decodierer mit Zusatzkanal-Decodierer zugeordnet. Zwischen den Leitungsendgeräten in bestimmten Abständen angeordneten Zwischengeneratoren sind für jede Übertragungsrichtung ein Zusatzkanal-Decodierer und ein Zusatzkanal-Codierer zugeordnet.

Bei solchen Übertragungssystemen mit Zusatzkanal, bei denen der Zusatzkanal aufgrund einer Coderegelverletzung realisiert wird, muß beim Abzweigen und Einblenden eines Zusatzkanals, insbesondere bei den Zwischenregeneratoren, auch der Hauptkanal jeweils vollständig decodiert und anschließend wieder codiert werden.

Aufgabe der vorliegenden Erfindung ist es, bei einer Übertragungseinrichtung der eingangs genannten Art einen Zusatzkanal zu schaffen, der mit möglichst geringem schaltungstechnischem Aufwand auskommt.

Diese Aufgabe wird bei einer gattungsgemäßen Übertragungseinrichtung dadurch gelöst, daß der Zusatzkanal mit einem zweiten ausgewogenen Blockcode getrennt codiert ist und der zu übertragende Datenstrom wechselweise aus einem oder mehreren Blöcken des Hauptkanals und einem Bit des block-codierten Zusatzkanals zusammengesetzt ist, wobei der für den Zusatzkanal verwendete Blockcode gegenüber dem für den Hauptkanal verwendeten Blockcode einen einfacheren Aufbau aufweist.

Für den Hauptkanal kann in üblicher Weise ein Blockcode mit relativ komplexer Coderegel verwendet werden. Die komplexe Coderegel ergibt bei der Blockcodierung eine nur geringfügige Erhöhung der Bitrate. Für den Zusatzkanal hingegen ist es von Vorteil, eine relativ einfache Coderegel zu verwenden, z.B. eine 1-Bit/2-Bit-Codierung. Der Erfindung liegt die Überlegung zugrunde, daß die relativ große Erhöhung der Bitrate des Zusatzkanals (beim 1-Bit/2-Bit-Code eine Verdoppelung) toleriert werden kann. Dafür ist der Aufwand zur Codierung und Decodierung sehr gering.

Der Erfindung liegt weiterhin die Erkenntnis zugrunde, daß für den Hauptkanal meist sogenannte ausgewogenen Blockcodes verwendet werden. Ausgewogene Blockcodes nennt man solche Blockcodes, bei denen sichergestellt ist, daß die verschiedenen, durch die Blockcodebildungsvorschrift erzeugten einzelnen Codeimpulse, unabhängig vom Inhalt der codierten Datenelemente, im Mittel stets gleich verteilt sind. Die Verwendung eines ausgewogenen Blockcodes im Zusatzkanal bietet bei einem mit ausgewogenem blockcode-codiertem Hauptkanal außerdem den Vorteil, daß auch das aus Hauptsignal und Zusatzsignal zusammengesetzte Multiplexsignal stets ausgewogen ist, ohne daß hierzu besonderer zusätzlicher Codierungs- bzw. Überwachungsaufwand betrieben werden muß.

Durch die wechselweise Übertragung von Blökken des block-codierten Hauptkanals und einem Bit des ebenfalls block-codierten Zusatzkanals ist eine einfache Einblendung bzw. Ausblendung des Zusatzkanals über relativ einfach auszugestaltende Multiplexer bzw. Demultiplexer möglich, da lediglich das Zusatzsignal zum Ein- und Ausblenden vollständig decodiert werden muß, während das Hauptsignal ohne Decodierung weitergeleitet werden kann. Der hierdurch gering haltbare Bauteileaufwand ergibt einen niedrigen Stromverbrauch, eine hohe Zuverlässigkeit und geringe Kosten.

Die Erfindung bietet allgemein den Vorteil, daß die Funktion des Zusatzkanals unabhängig vom Inhalt des Hauptkanals ist. Eine Anpassung des Übertragungsverfahrens an die benötigte Übertragungsrate im Zusatzkanal ist durch die Übertragung von mehreren Blöcken des Hauptkanals abwechselnd mit einem Bit des Zusatzkanals möglich.

Besonders vorteilhaft ist es, für eine 1-Bit/2-Bit-Codierung des Zusatzkanals einen sogenannten CMI-Code (code mark inversion) oder einen CD-Code (Conditioned Diphase) zu verwenden. Diese Codes ermöglichen eine einfache Codier- und Decodiereinrichtung für den Zusatzkanal sowie eine einfache Überwachung der Wortsynchronität. Als Kriterium für die Herstellung der Wortsynchronität können sowohl die Coderegel des Zusatzkanals als auch die des Hauptkanals dienen. Da beide Codes im Mittel gleichviele Einsen und Nullen aufweisen, also ausgewogen sind, gilt dies in vorteilhafter Weise auch für das aus dem Hauptsignal und Zusatzsignal gebildete Multiplexsignal.

Im folgenden wird die Erfindung anhand eines in der Zeichnung dargestellten Ausführungsbeispiels näher beschrieben und erläutert.

Es zeigen:

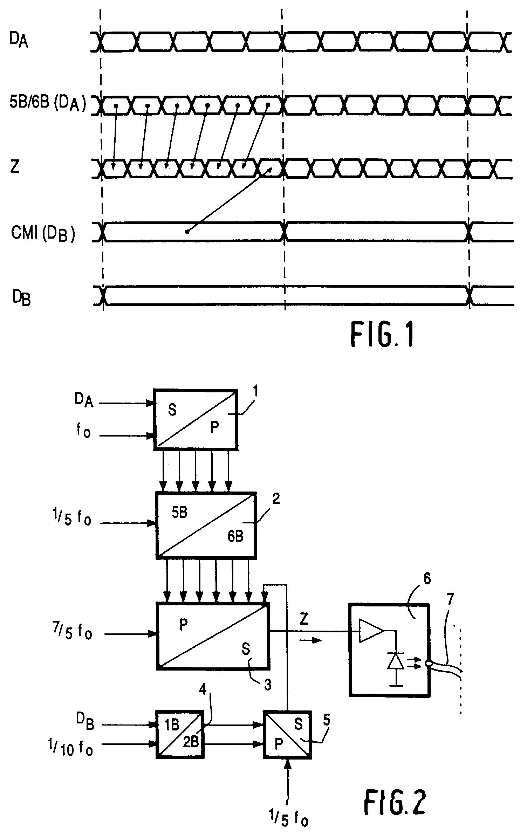

Fig. 1 ein aus Hauptsignal und Zusatzsignal gebildetes Multiplexsignal.

Fig. 2 ein Leitungsendgerät zum Senden des Multiplexsignals.

Fig. 3 einen Zwischenregenerator mit Ein- und Ausblendung des Zusatzkanals.

Fig. 4 ein Leitungsendgerät zum Empfangen des Multiplexsignals.

Im Ausführungsbeispiel beträgt die Datenrate eines Zusatzsignals $D_B$ nur 1/10 der Datenrate eines Hauptsignals $D_A$. In einem Serien/Parallel-Wandler 1, der mit der Datenrate $f_0$ des Hauptsignals $D_A$ getaktet wird, werden jeweils fünf aufeinanderfolgende Bits des Hauptsignals $D_A$ in jeweils aus fünf Bits bestehende Datenworte umgesetzt. Diese Datenwörter sind einem 5B/6B-Coder 2 zugeführt, der mit einem fünftel der Datenrate des Hauptsignals getaktet ist. Der 5B/6B-Coder 2 ordnet den 5 Bit-Datenwörtern jeweils entsprechend einer 5B/6B-Coderegel entsprechende 6 Bit breite Codewörter $5B/6B(D_A)$ zu. Diese an den sechs Ausgängen des 5B/6B-Umwandlers 2 abgreifbaren Bits des Codewortes sind den ersten sechs Eingängen eines Parallel/Serien-Wandlers 3 zugeführt. Das Zusatzsignal $D_B$ ist einem CMI-Coder 4 zugeführt, der mit der Datenrate des Zusatzsignals getaktet ist. Die zu jedem Bit des Zusatzsignals zugeordneten 2 Bits des CMI-Leitungscodes sind einem zweiten Parallel/Serien-Wandler 5 zugeführt, der nur mit der Hälfte der Datenrate des Zusatzsignals getaktet wird. Der Ausgang des zweiten Parallel/Serien-Wandlers 5 ist an den siebten Eingang des ersten Parallel/Serien-Wandlers 3 zugeführt. Der erste Parallel/Serien-Wandler 3 wird mit 7/5 der Taktrate des Hauptsignals getaktet. Auf diese Weise entsteht am Ausgang des ersten Parallel/Serien-Wandlers 3 ein Datenstrom Z, der jeweils aus 6 Bits des 5B/6B-Leitungscodes und einem Bit des CMI-Leitungscodes $CMI(D_B)$ zusammengesetzt ist. Dieser Datenstrom wird auf einen optischen Sender 6 gegeben, welcher den Datenstrom über eine Glasfaser 7 weiterleitet.

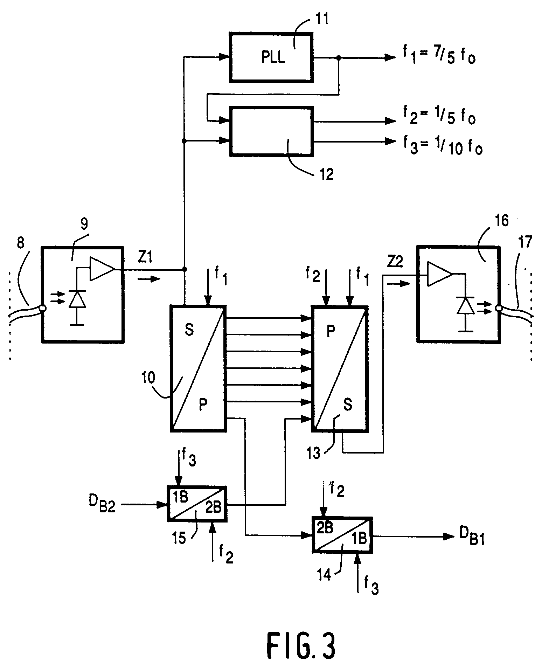

In Fig. 3 ist ein Zwischenregenerator dargestellt, der aus einem ankommenden Datenstrom Z1 ein darin enthaltenes Zusatzsignal $D_{B1}$ abzweigt und ein zweites Zusatzsignal $D_{B2}$ in einen abgehenden Datenstrom Z2 einfügt. Der über eine Glasfaser 8 ankommende Datenstrom Z1 wird in einem optischen Empfänger 9 zu einem aus einzelnen Bits bestehenden Datenstrom umgesetzt. Der Datenstrom Z1 ist einem zwischenregeneratorseitigem Serien/Parallel-Wandler 10 sowie einer Anordnung zur Taktrückgewinnung 11 und einer Einrichtung zur Wortstrukturerkennung 12 zugeführt. Mittels einer Phasenregeleinrichtung (PLL) wird der Sendetakt des Datenstroms Z zurückgewonnen. Der zurückgewonnene Datentakt ist ebenfalls der Einrichtung zur Wortstrukturerkennung 12 zugeführt. Aufgrund der beschriebenen laufenden digitalen Summe (LDS) der 5B/6B-Blockcodierung erkennt die Einrichtung zur Wortstrukturerkennung 12 jeweils den Beginn des aus 7 Bit bestehenden gesendeten Datenwortes. Jeweils zu Beginn eines gesendeten Datenwortes erzeugt sie einen Impuls und durch Binärteilung aufeinanderfolgende Impulse bei jedem zweiten Impuls der sich auf diese Weise ergebenden Impulsfolge $f_2$ eine zweite Impulsfolge $f_3$.

Die jeweils ersten sechs Ausgänge des Serien/Parallel-Wandlers 10 sind den ersten sechs Eingängen eines Parallel/Serien-Wandlers 13 zugeführt. Der siebte Ausgang des Serien/Parallel-Wandlers 10 ist einem CMI-Decoder 14 zugeführt, der mit der zweiten Impulsfolge $f_3$ getaktet ist. Auf diese Weise wird jeweils an der richtigen Stelle jeweils das eine Bit des CMI-codierten Zusatzsignals ausgesondert und aus jeweils zwei aufeinanderfolgenden Bits der ausgesonderten Bits der ursprüngliche Dateninhalt des ausgesandten Zusatzsignals zurückgewonnen.

Ein neu einzufügendes Zusatzsignal $D_{B2}$ ist einem zwischengeneratorseitigen CMI-Coder 15 zugeführt, dem ebenfalls die Impulsfolgen $f_2$ und $f_3$ zugeführt sind. Der Ausgang des CMI-Coders 15 ist dem siebten Eingang des Parallel/Serien-Wandlers 13 zugeführt. Mit jedem Impuls der ersten Impulsfolge $f_2$ werden die an den sieben Eingängen des Parallel/Serien-Wandlers 13 anliegenden Bits übernommen und mit der zurückgewonnenen Taktfrequenz $f_1$ des Datensignals aus dem Parallel/Serien-Wandler 13 ausgeschoben. Der auf diese Weise gewonnene neue Datenstrom Z2, bei dem nur diejenigen Bits gegenüber dem Eingangssignal geändert sind, die das Zusatzsignal betreffen, ist einem zwischengeneratorseitigen optischen Sender 16 zugeführt, der das Datensignal Z2 über eine Glasfaserleitung 17 aussendet.

Durch die bitweise Einbettung des Zusatzsignals in das Hauptsignal ist, wie beschrieben wurde, eine einfache Ein- und Ausblendung des Zusatzsignals möglich, ohne daß das ursprüngliche Hauptsignal decodiert werden muß.

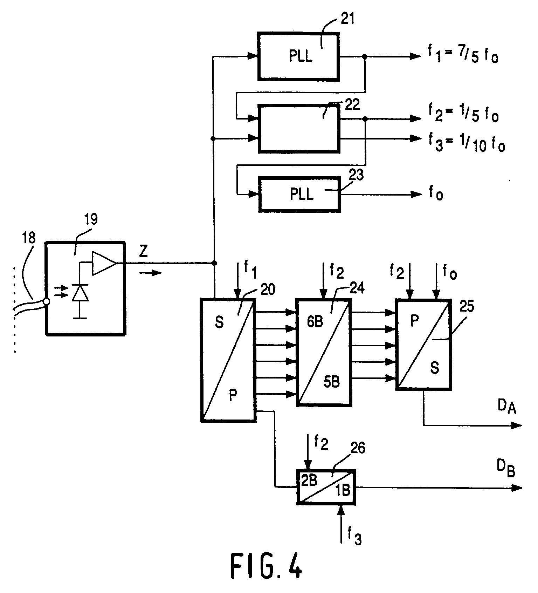

Fig. 4 zeigt ein Leitungsendgerät zum Empfangen und Trennen eines über eine Glasfaserleitung 18 ankommenden Datenstroms Z. Das von einem optischen Empfänger 19 umgesetzte Datensignal Z ist wie beim Zwischenregenerator einem empfangsseitigen Serien/Parallel-Wandler 20, einer empfangsseitigen Einrichtung zur ersten Taktrückgewinnung 21 und einer empfangsseitigen Einrichtung zur Wortstrukturerkennung 22 zugeführt. Die erste Einrichtung zur Taktrückgewinnung 21 und die Einrichtung zur Wortstrukturerkennung 22 erzeugen genauso wie beim Zwischenregenerator beschrieben ein erstes Taktsignal $f_1$ mit der Datenrate des Datenstroms Z und zwei Impulsfolgen $f_2$ bzw. $f_3$ mit der Datenrate des CMI-codierten Zusatzsignals bzw. der Datenrate des Zusatzsignals $D_B$. Die erste Impulsfolge $f_2$ ist einer zweiten Taktrückgewinnungseinheit 23 zugeführt, in der mittels einer Phasenregelschleife (PLL) ein der Datenrate des Hauptsignals $D_A$ entsprechendes Taktsignal $f_0$ zurückgewonnen wird.

Der Serien/Parallel-Wandler 20 wird mit dem ersten Taktsignal $f_1$ getaktet. Seine ersten sechs Ausgänge sind einem 6B/5B-Decoder 24 zugeführt. Durch die Taktimpulse der ersten Impulsfolge $f_2$ wird zu den entsprechenden Zeitpunkten aus den 6 Bit-breiten Datenworten an den Eingängen des 6B/5B-Decodierers 24 das dem ursprünglich codierten 5 Bit-breiten Datenwort entsprechende Datenwort zurückgewonnen und einem Parallel/Serien-Wandler 25 zugeführt. Aus dem Parallel/Serien-Wandler 25 werden die einzelnen Datenbits mit der ursprünglichen Datenrate $f_0$ seriell ausgelesen und ergeben somit das ursprüngliche Datensignal $D_A$.

Der siebte Ausgang des Serien/Parallel-Wandlers 20 ist einem CMI-Decoder 26 zugeführt. Aus jeweils zwei aufeinanderfolgenden Datenbits des CMI-codierten Zusatzsignals erzeugt der CMI-Decoder 26 wieder ein Bit des ursprünglichen Zusatzsignals $D_B$.

**Patentansprüche**

1. Übertragungseinrichtung für eine digitale Übertragungsstrecke mit einem blockcode-codiertem Hauptkanal und mit einem Zusatzkanal, dadurch gekennzeichnet, daß der Zusatzkanal ($D_B$) mit einem zweiten ausgewogenen Blockcode getrennt codiert ist und der zu übertragende Datenstrom (Z) wechselweise aus einem oder mehreren Blöcken des Hauptkanals ($D_A$) und einem Bit des blockcodierten Zusatzkanals ($D_B$) zusammengesetzt ist, wobei der für den Zusatzkanal verwendete Blockcode gegenüber dem für den Hauptkanal verwendeten Blockcode einen einfacheren Aufbau aufweist.

2. Übertragungseinrichtung nach Anspruch 1, dadurch gekennzeichnet, daß der für den Zusatzkanal verwendete Blockcode ein CMI-Code ist.

3. Übertragungseinrichtung nach Anspruch 1, dadurch gekennzeichnet, daß der für den Zusatzkanal verwendete Blockcode ein CD-Code ist.

4. Übertragungseinrichtung nach einem der Ansprüche 1 bis 3, dadurch gekennzeichnet, daß in einem zum Senden vorgesehenen Leitungsendgerät das Ausgangssignal eines Ein-Bit/Zwei-Bit-Codierers (4) einem Parallel/Serien-Wandler (5) zugeführt ist, dessen Ausgangssignal einem Eingang eines weiteren Parallel/Serien-Wandlers (3) zugeführt ist, wobei den anderen Eingängen des weiteren Parallel/Serien-Wandlers (3) die Ausgänge eines Fünf-Bit/Sechs-Bit-Codierers (2) zugeführt sind und der Ausgang des zweiten Parallel/Serien-Wandlers (3) einem Sender zugeführt sind.

5. Übertragungseinrichtung nach einem der Ansprüche 1 bis 3, dadurch gekennzeichnet, daß in einem zum Empfang vorgesehenen Leitungsendgerät ein erster Serien/Parallel-Wandler (20) vorgesehen ist, von dem ein Ausgang einem Zwei-Bit/Ein-Bit-Umsetzer (26) und dessen andere Ausgänge einem Sechs-Bit/Fünf-Bit-Umsetzer (24) zugeführt sind.

6. Übertragungseinrichtung nach einem der Ansprüche 1 bis 2, dadurch gekennzeichnet, daß eine als Zwischenregenerator vorgesehene Übertragungseinrichtung jeweils einen Serien/Parallel-Wandler (10) und einen Parallel/Serien-Wandler (13) aufweist, wobei ein Ausgang des Serien/Parallel-Wandlers einem Zwei-Bit/Ein-Bit-Umsetzer (14) und die anderen Ausgänge des Serien/Parallel-Wandlers (10) den Eingängen des Parallel/Serien-Wandlers (13) zugeführt sind und dem verbleibendem Eingang des Parallel-Serien-Wandlers (13) das Ausgangssignal eines Ein-Bit/Zwei-Bit-Umsetzers (15) zugeführt ist.

FIG.1

FIG.2

FIG.3

FIG. 4